Europäisches Patentamt

European Patent Office

Office européen des brevets

(11) Numéro de publication: **0 232 564 B1**

(12) **FASCICULE DE BREVET EUROPEEN**

(45) Date de publication de fascicule du brevet:
19.06.91

(51) Int. Cl.⁵: **G01R 1/073**

(21) Numéro de dépôt: 86202297.7

(22) Date de dépôt: **16.12.86**

(54) Dispositif de test pour pastille de circuit intégré hyperfréquences.

(30) Priorité: 20.12.85 FR 8518921

(43) Date de publication de la demande:
19.08.87 Bulletin 87/34

(45) Mention de la délivrance du brevet:
19.06.91 Bulletin 91/25

(84) Etats contractants désignés:
**DE FR GB IT**

(56) Documents cités:
**DE-A- 2 708 640**
**US-A- 3 496 464**
**US-A- 3 525 937**
**US-A- 4 161 692**
**US-A- 4 554 505**

INSTITUT OF ELECTRICAL AND ELECTRO-
NICS ENGINEERS, semiconductor test symposium, Cherry Hill, New Jersey, 5-7 novembre 1974, pages 171-176, IEEE Computer Society & the Philadelphia section of the IEEE,
US; B.H. McGAHEY: "Test probe for high
speed functional testing of silicon IC's"

(73) Titulaire: **LABORATOIRES D'ELECTRONIQUE
PHILIPS
3, Avenue Descartes
F-94450 Limeil-Brévannes(FR)FR**

Titulaire: **N.V. Philips' Gloeilampenfabrieken
Groenewoudseweg 1
NL-5621 BA Eindhoven(NL)DE GB IT**

(72) Inventeur: **Binet, Michel Joseph Marie Société
Civile S.P.I.D.
209, rue de l'Université
F-75007 Paris(FR)**

(74) Mandataire: **Landousy, Christian et al
Société Civile S.P.I.D. 156, Boulevard Haussmann
F-75008 Paris(FR)**

## Description

L'invention concerne un dispositif de test pour pastille de circuit intégré hyperfréquences, pour transporter les signaux d'entrées/sorties de ce circuit, au moyen de lignes hyperfréquences d'impédance caractéristique adaptée vers des appareils de mesure.

L'invention trouve son application dans le domaine de la fabrication des circuits intégrés hyperfréquences. En cours de fabrication, ou en fin de fabrication des circuits intégrés hyperfréquences, les pastilles (PUCES) portant ces circuits doivent pouvoir être testées d'une façon simple et surtout très précise.

Un dispositif de test pour circuit intégré est connu du brevet US-A-3 525 937. Selon ce document le dispositif de test comprend un système pour prélever les signaux sur les plots d'entrées-sorties du circuit intégré qui est formé d'une couche sur une première face de laquelle est réalisé un plan de masse continu et sur la seconde face de laquelle sont disposées une ou plusieurs lames ressort métalliques faisant office d'une part de lignes hyperfréquences de type microruban et d'autre part de contact avec un ou des plots d'entrées-sorties du circuit intégré chacun préalablement muni d'une boule pour améliorer le contact. Ces rubans-lames de ressort sont prévus en fonction de l'épaisseur de la couche pour former une ligne hyperfréquences microruban d'une impédance caractéristique donnée. Ces lignes sont disposées par exemple radialement autour du circuit intégré. Des moyens sont en outre fournis pour réaliser un contact correct avec le plan de masse continu de la première face de la couche.

Or, il est très difficile de pratiquer les tests directement sur la pastille de circuit intégré. Et d'autre part, dans le domaine des hyperfréquences, il ne peut être question de transporter les signaux de tests par de simples fils connectés aux plots d'entrée/sortie de la pastille. Les signaux doivent impérativement être transportés par des lignes hyperfréquences d'impédance caractéristique donnée.

C'est pourquoi, la pastille de circuit intégré est mise en place sur un support auxiliaire qui comporte une pluralité de lignes hyperfréquences d'impédance connue. Les plots d'entrée/sortie de la pastille sont connectés à l'une des extrémités de ces lignes et les appareils de mesure, destinés à enregistrer les résultats des tests sont connectés à l'autre extrémité de ces lignes au moyen de lignes coaxiales classiques d'impédance caractéristique adaptée.

Un autre dispositif de test pour circuits intégrés est connu du brevet US-A- 3 882 597. Mais si ce document pose bien le problème des contacts et connexions entre le circuit à tester et le dispositif de test, il n'enseigne pas de solution pour tester un circuit hyperfréquence dont les signaux sont transportés par des lignes hyperfréquences.

En particulier ce dispositif ne peut être adapté à l'application de test incluant des lignes hyperfréquences car la mesure ne pourrait être effectuée du fait que le couplage entre les lignes hyperfréquences utilisées pour raccorder le circuit intégré aux connecteurs coaxiaux reliés aux appareils de mesure, dépend de la pression entre la masse du dispositif et les plans de masse des lignes hyperfréquences. Si le serrage du dispositif de test sur les aires de masses desdites lignes n'est pas adéquat, alors le couplage entre ces lignes est trop fort et les mesures sont faussées.

C'est pourquoi la présente invention propose un nouveau dispositif de test qui s'applique au cas décrit dans le préambule et qui permet de résoudre ce problème.

Selon l'invention ce problème est résolu à l'aide d'un dispositif en outre caractérisé en ce qu'il comprend :

- un premier sous-ensemble constitué par un substrat isolant ou diélectrique portant d'une part, fixé sur l'une de ses faces la pastille de circuit intégré, et d'autre part, réalisé sur la même face dite face avant, un réseau de lignes hyperfréquences du type coplanaire disposé selon un motif géométrique propre à transporter les signaux issus des entrées/sorties du circuit intégré vers les régions périphériques du substrat,
- un deuxième sous-ensemble pour recevoir le substrat muni du circuit intégré et du réseau coplanaire, ce deuxième sous-ensemble présentant en outre des moyens pour réaliser une pression des aires de masse du réseau coplanaire sur une aire de masse de ce deuxième sous-ensemble, ainsi que des moyens pour réaliser un contact électrique franc et reproductible entre les conducteurs centraux du réseau coplanaire et les conducteurs centraux des lignes coaxiales alimentant les appareils de mesures.

Selon l'invention ce dispositif peut être encore caractérisé en ce que, pour recevoir le substrat muni de circuit intégré et du réseau coplanaire, le second sous-ensemble est principalement constitué d'une dite première pièce, et d'une dite seconde pièce, présentant chacune une surface plane polie, fixées en regard l'une de l'autre avec un décrochement, de telle manière que ce décrochement constitue un plan de masse appartenant à ladite première pièce, approprié à servir de logement au substrat, la face avant du substrat prenant appui sur la face plane et polie du décrochement, et en ce que, pour servir de logement aux connecteurs coaxiaux des lignes hyperfréquences alimentant les appareils de mesure, le second sous-ensemble comporte, pratiquées dans les premières et secondes pièces des ouvertures circulaires, en nombre identique à celui des lignes coplanaires, distribuées à la périphérie desdites premières et secondes pièces selon une géométrie appropriée à ce que chaque conducteur central de connecteur coaxial vienne en coïncidence avec une extrémité de conducteur central de ligne coplanaire, en sorte que du fait de la position de ces ouvertures, seules les aires de masse des lignes coplanaires prennent appui sur le décrochement servant de masse, alors que les conducteurs centraux des lignes coplanaires prennent appui sur les conducteurs centraux des connecteurs coaxiaux.

Le dispositif de test selon l'invention présente donc de nombreux avantages dont entre autres :

- un excellent contact de masse sur toute la périphérie du substrat qui porte les lignes coplanaires,
- une continuité d'impédance caractéristique entre le conducteur central des lignes coplanaires et le conducteur central des lignes coaxiales qui assurent la liaison entre la ligne coplanaire et l'appareil de mesure,
- un contact franc et reproductible entre le conducteur central de la ligne coplanaire et le conducteur central de la ligne coaxiale,
- une grande commodité d'emploi, une charge et une décharge aisée du substrat comportant les lignes coplanaires et le circuit intégré à tester, et une bonne reproductibilité des liaisons électriques,
- une mise en oeuvre des tests qui est simple et d'un coût réduit et ne vient pas ainsi grever le coût de fabrication du circuit intégré,
- enfin une précision extrêmement grande sur les tests puisque ces derniers sont pratiqués directement sur la pastille de circuit intégré, à une étape de la fabrication où cette pastille est encore dépourvue de boîtier.

L'invention sera mieux comprise à l'aide de la description suivante illustrée par les figures annexées dont :

la figure 1 qui représente un exemple de réalisation de lignes coplanaires sur un support auxiliaire, cette représentation montrant environ un huitième dudit support vu du dessus,

la figure 2 qui montre en coupe le dispositif de test selon l'invention dans une représentation simplifiée,

la figure 3 qui montre en coupe le dispositif de test selon l'invention dans une représentation détaillée.

Le dispositif de test selon l'invention comprend donc deux sous-ensembles.

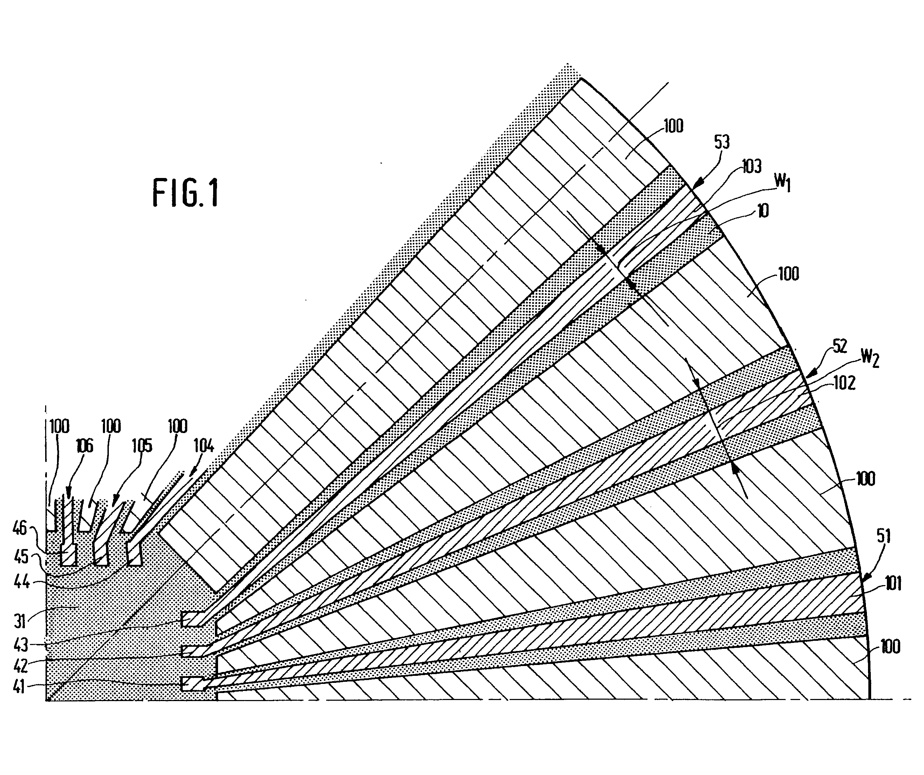

Le premier sous-ensemble représenté sur la figure 1 est formé par un support auxiliaire 10, par exemple en alumine, sur l'une des faces 11 duquel sont réalisées des lignes hyperfréquences de type coplanaire en un nombre égal au nombre des entrées/sorties à tester d'une pastille de circuit intégrée, laquelle prend place dans la zone 31 de cette face 11. Ce support auxiliaire, dit substrat 10, pourra être aussi bien carré que circulaire. D'une façon pratique, l'homme du métier adoptera facilement la forme carrée lorsque le substrat 10 comportera un nombre de lignes inférieur à 10, et la forme circulaire lorsque le nombre des lignes exédera 10. Mais cette limite n'a aucun caractère impératif et le choix est purement laissé à l'utilisateur.

Par contre, les lignes hyperfréquences 101,102 etc réalisées sur le substrat 10 sont choisies du type dit coplanaire.

Par lignes coplanaires, il faut entendre des lignes en forme de ruban métallisé de largeur $W_1$ compris entre deux grandes aires métallisées constituant la masse. Le ruban métallisé forme le conducteur central de la ligne, les aires de masses étant séparées d'une distance $W_2$. De plus, le ruban formant le conducteur central et les plans de masse sont réalisés sur la même face 11 du substrat 10. Dans ces conditions l'impédance caractéristique d'une telle ligne hyperfréquence ne dépend que du rapport $W_1/W_2$.

L'intérêt de cette forme de réalisation de lignes hyperfréquence est très grand.

En premier lieu, du fait que les conducteurs centraux et la masse sont réalisés sur la même face du substrat, les connexions entre le circuit intégré qui prend place dans la zone 31, et ces lignes, peuvent être réalisées directement, sans faire appel, comme dans les technologies dites triplaques ou bifilaires, à des trous métallisés pour faire passer les connexions d'une face à l'autre du substrat, lequel est dans ces technologies pourvu de métallisations sur les deux faces. Ceci est d'un grand avantage car les connexions par trous métallisés offrent un certain pourcentage d'échec dans les branchements électriques.

En second lieu, du fait que l'impédance ne dépend que du rapport $W_1/W_2$, et non comme dans les autres technologies citées du rapport $W/e$ où $W$ est la largeur du ruban conducteur central et $e$ l'épaisseur du diélectrique, il est alors aisé dans la technologie des lignes coplanaires de réaliser des lignes d'impédance courante comme 50 Ω par exemple même avec des lignes étroites. Il est par conséquent facile à l'aide de cette technologie de faire arriver un grand nombre de lignes d'impédance voulue, telle que 50 Ω , à proximité immédiate d'une pastille de circuit intégré (PUCE) comme il est montré sur la figure 1. Les plots d'entrée/sortie de cette pastille sont raccordés par un procédé laissé au choix de l'homme du métier aux terminaisons 41, 42, 43, 44, 45, 46 etc des lignes 101, 102, 103, 104, 105, 106 etc, la pastille de circuit intégré étant disposée dans la zone 31.

La configuration de lignes représentée figure 1 n'est bien entendu donnée qu'à titre d'exemple de réalisation. De nombreuses autres configurations sont possibles pour se mettre en accord avec la forme et les dimensions de la pastille de circuit intégré et le nombre des entrées/sorties.

Le test des entrées/sorties de la pastille de circuit intégré se fera par l'intermédiaire des lignes réalisées sur le support auxiliaire 10, à l'extrémité 51, 52, 53 etc des lignes 101, 102, 103 etc respectivement.

A cet effet, le dispositif selon l'invention comporte un deuxième sous-ensemble qui permet de prendre des contacts fiables et reproductibles sur ces lignes 101, 102, 103 etc à l'aide de lignes coaxiales classiques amenant les signaux sur les appareils de mesures.

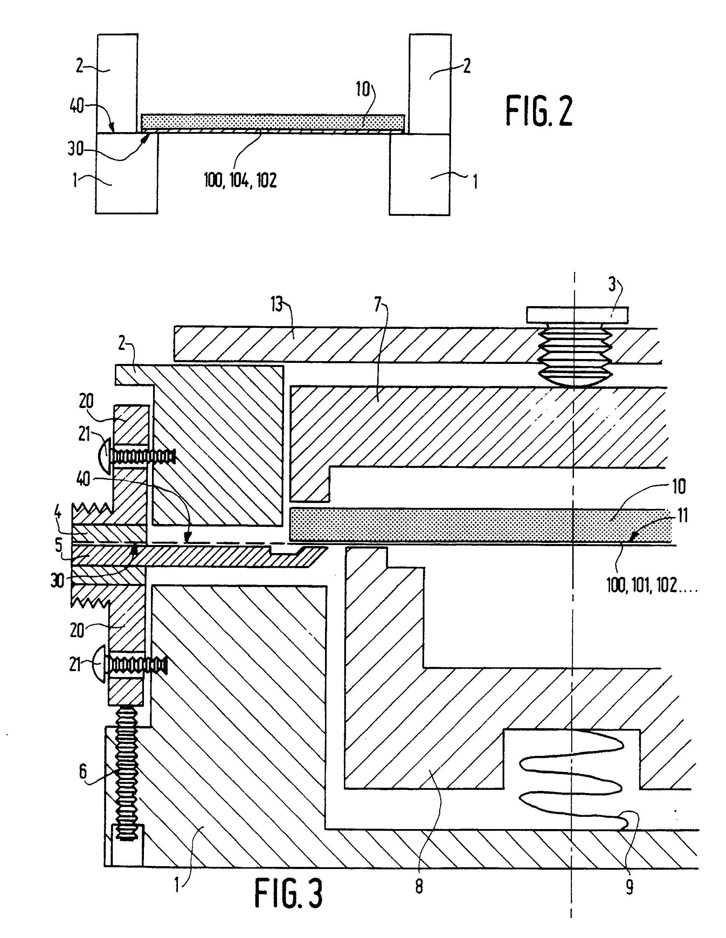

Ce deuxième sous-ensemble est représenté de façon simplifiée sur la figure 2. Il comporte deux pièces principales reposant l'une sur l'autre, 1 et 2, qui à titre d'exemple de réalisation peuvent être concentriques et de révolution, lorsque le substrat 10 est circulaire.

Les parties les plus importantes de ces deux pièces sont la surface plane 30 pour la pièce 1, et la surface plane 40 pour la pièce 2.

Les surfaces 30 et 40 sont usinées avec une grande précision tant sur la planéité que sur l'état de surface qui sera polie. Ces surfaces sont ensuite placées en regard l'une de l'autre.

Le diamètre interne de la pièce 2 est prévu supérieur au diamètre interne de la pièce 1, de sorte qu'une partie de la surface 30 se trouve ainsi disponible pour recevoir la face 11 du substrat 10 muni de la pastille de micro-circuit reliée aux lignes et aux masses de façon appropriée.

Des évidements sont prévus dans la pièce 1 et en regard dans la pièce 2 en coïncidence avec les parties de la surface 11 qui porte les conducteurs centraux 101, 102, 103 etc.

Dans ces évidements entre les pièces 1 et 2 circulent alors des lignes coaxiales 4 de type classique qui sont ainsi amenées en direction de, et à proximité desdits conducteurs centraux 101, 102 etc.

Les évidements pratiqués dans les pièces 1 et 2 sont faits avec une précision telle que les lignes coaxiales 4 sont mises en position dans ces évidements avec une grande précision latérale.

La figure 3 montre plus en détail cette disposition. Une certaine liberté de réglage est laissée sur les lignes coaxiales 4 dans le positionnement transversal.

Les lignes coaxiales 4 dont le conducteur central port la référence 5, sont maintenues vis à vis des pièces 1 et 2 par le support 20 et les vis 21.

La mise en position, perpendiculairement à la face avant du substrat, des conducteurs centraux 5 des lignes (ou connecteurs) 4 est assurée de façon précise par la vis 6 qui permet d'ajuster la pression du conducteur central 5 sur la ligne 101 ou 102 etc portée par la face 11, par la propre déformation élastique du conducteur 5. Ce réglage doit être fait une seule fois, lors de la première utilisation du dispositif.

En position de test, la face 11 du substrat 10 est pressée contre la surface 30 de la pièce 1 par une pièce 7 présentant une faible constante diélectrique. Cette pièce 7 peut être par exemple en plexiglass.

Le matériau choisi pour constituer la pièce 7 doit obligatoirement présenter une faible constante diélectrique afin d'éviter les couplages capacitifs. On rappelle que l'on a affaire ici à des mesures hyperfréquences à l'aide de lignes hyperfréquences, ce qui conduit à des particularités du dispositif de test selon l'invention qui n'apparaissent pas dans le dispositif de test connu de l'état de la technique.

La pièce 7 possède en outre un évidement central de manière à ce que la poussée exercée par la pièce 7 ne s'exerce sur le substrat qu'en regard de la partie de la surface 30 sur lequel la face 11 repose.

Enfin un pièce 8, qui doit comme la pièce 7 être isolante pour les raisons citées précedemment, coulisse librement dans le cas 1 et vient presser le côté actif 11 du substrat 10, étant portée par un ressort 9 de façon à pousser le substrat 10 vers la pièce 7.

Le procédé d'utilisation du dispositif de test selon l'invention comprend donc les étapes suivantes :

- Mise en place de la pastille de circuit intégré dans la zone 31 sur la face 11 du substrat 10 qui porte des lignes coplanaires 101, 102, 103 etc et des aires de masse 100. Raccordement des plots d'entrées/sorties du circuit intégré avec les extrémités 41, 42, 43 etc des conducteurs centraux des lignes coplanaires.

- Mise en place du substrat 10, face 11 en regard de la pièce 8, de manière que les conducteurs centraux se trouvent en face des évidements et que les aires de masse 100 se trouvent en regard de la face 30 de la pièce 1.

- Mise en coïncidence des conducteurs centraux 101, 102 etc avec les conducteurs centraux 5 des lignes coaxiales 4.

- Mise en place de la pièce 7, qui vient presser à l'aide de la vis 3 le substrat 10 sur la face 30, en comprimant le ressort 9 jusqu'à ce que les contacts électriques entre les conducteurs 5 et 101, 102 ... etc soient établis, ainsi qu'entre les zones métallisées 100 et la surface métallique 30. La pression entre ces différentes parties est trouvée idéale lorsque, en mesurant le couplage hyperfréquence entre deux lignes coplanaires, la valeur de ce couplage est trouvée minimale. Le serrage ne peut être arrêté avant d'avoir obtenu ce couplage minimal, mais il ne doit pas non plus être poursuivi au-delà, sous peine de rompre le substrat 10.

Dans l'exemple de réalisation représenté figure 3, c'est un système simple d'étrier 13 et de vis 3 qui permet de réaliser ce serrage avec la précision qu'il est impératif d'obtenir puisque de ce serrage dépend ultérieurement la précision des mesures et leur répétitivité.

On notera que l'étrier 13, les parties 1 et 2 peuvent être fixés les uns aux autres par un système de blocage non représenté pour des raisons de simplification du dessin. Ce blocage peut être fait par vis par exemple.

Egalement dans un exemple de réalisation du dispositif les corps 1 et 2 peuvent être en bronze.

Les surfaces 30 et 40 sont alors dorées pour assurer des contacts électriques reproductibles.

Les connecteurs coaxiaux 4 sont par exemple des embases tronquées telles que RADIALL marque déposée utilisées de façon connue pour le raccordement avec des lignes de type bifilaire ou triplaques à microruban.

La mise en place précise des lignes coaxiales est enfin assurée par les opérations suivantes :
- Les connecteurs coaxiaux 4 sont mis en place à l'aide des pièces 20 et des vis 21, de façon lâche.
- Un substrat 10' de référence dont la surface 11' est entièrement métallisée, par exemple par dorure est mise en place sur le corps 1, et serré à l'aide de la vis 3 pour appliquer la face 11' sur la face 30. La hauteur de chaque conducteur central 5 est alors ajustée au moyen de sa vis 6 de réglage vertical, jusqu'à ce qu'il y ait contact électrique entre le conducteur central 5 de la ligne coaxiale et la surface 11' entièrement métallisée. Le conducteur central 5 se trouve alors en contact avec le potentiel de masse puisque la surface 11' métallisée est par ailleurs en contact avec la surface 30 qui constitue la masse.
- La pression du conducteur central 5 sur la surface métallisée 11' du substrat de référence est alors légèrement augmentée par rapport à la position où l'on obtient juste le contact. A titre d'exemple, cette légère augmentation de la pression pourra être obtenue en tournant la vis 6 pour la faire avancer d'une distance d'environ 0,2 mm. Le conducteur central se trouve alors en position de flexion. Cette flexion assure une pression de quelques centaines de grammes qui permet d'obtenir un contact reproductible.

Cette opération de réglage préliminaire de la pression des conducteurs centraux 5 des lignes coaxiales 4 de mesure est effectuée à l'aide de ce substrat 10' de référence sur tous les conducteurs centraux utilisés dans le dispositif.

Le dispositif de test selon l'invention permet donc de réaliser le raccord entre le circuit intégré à tester et les lignes coaxiales de mesures qui portant les signaux aux appareils de mesure, avec tous les avantages qui ont été cités.

Le contact de masse est excellent du fait que le plan de masse 30 est réalisé avec une grand précision sur la planéité. Cette précision sur la planéité de la surface 30 peut être obtenu du fait que c'est l'ensemble de la surface 30 qui est soumise au façonnage et au polissage et non une seule couronne en décrochement des pièces 1 et 2 comme il pourrait paraître suffisant de réaliser, ce qui ne pourrait être fait que par un usinage peu précis, si les pièces 1 et 2 étaient en une seule partie.

Enfin l'ensemble du dispositif est d'une utilisation aisée au montage, mais également du démontage puisque dans ce cas, il n'est nul besoin de retoucher au réglage des connecteurs centraux 5, et que le ressort 9 repousse le substrat 10 vers la sortie du dispositif.

## Revendications

1. Dispositif de test pour pastille de circuit intégré hyperfréquences pour transporter les signaux hyperfréquences d'entrées/sorties de ce circuit, au moyen de lignes hyperfréquences (101, 102...) d'impédance caractéristique adaptée, vers des appareils de mesures caractérisé en ce qu'il comprend :
   - un premier sous-ensemble constitué par un substrat (10) isolant ou diélectrique portant d'une part, fixé sur l'une de ses faces (11) la pastille de circuit intégré, et d'autre part, réalisé sur la même face (11) dite face avant, un réseau de lignes hyperfréquences (101, 102...) du type coplanaire disposé selon un motif géométrique propre à transporter les signaux issus des entrées/sorties du circuit intégré vers les régions périphériques du substrat (10),
   - un deuxième sous-ensemble pour recevoir le substrat (10) muni du circuit intégré et du réseau coplanaire, ce deuxième sous-ensemble présentant en outre des moyens pour réaliser une pression des aires de masse (100) du réseau coplanaire sur une aire de masse de ce deuxième sous-ensemble, ainsi que des moyens pour réaliser un contact électrique franc et reproductible entre les conducteurs centraux (51, 52, 53) du réseau coplanaire et les conducteurs centraux des lignes coaxiales alimentant les appareils de mesures.

2. Dispositif selon la revendication 1, caractérisé en ce que, pour recevoir le substrat (10) muni du circuit intégré et du réseau coplanaire (101, 102...), le second sous-ensemble est principalement constitué d'une dite première pièce (1), et d'une dite seconde pièce (2), présentant chacune une surface plane polie (30, 40), fixées en regard l'une de l'autre avec un décrochement, de telle manière que ce décrochement constitue un plan de masse appartenant à ladite première pièce, approprié à servir de logement au substrat, la face avant du substrat prenant appui sur la face plane et polie du décrochement, et en ce que, pour servir de logement aux connecteurs coaxiaux (4) des lignes hyperfréquences alimentant les appareils de mesure, le second sous-ensemble comporte, pratiquées dans les premières et secondes pièces des ouvertures circulaires, en nombre identique à celui des lignes coplanaires, distribuées à la périphérie desdites premières et secondes pièces selon une géométrie appropriée à ce que chaque conducteur central (5) de connecteur coaxial (4) vienne en coïncidence avec une extrémité (51, 52...) de conducteur central de ligne coplanaire, en sorte que du fait de la position de ces ouvertures, seules les aires de masse des lignes coplanaires prennent appui sur le décrochement servant de masse (100), alors que les conducteurs centraux (51, 52 ) des lignes coplanaires prennent appui sur les conducteurs centraux (5) des connecteurs coaxiaux (4).

3. Dispositif selon la revendication 2, caractérisé en ce que les moyens pour réaliser la pression des aires de masse des lignes coplanaires sur l'aire de masse constituée par le décrochement sont formés par une dite troisième pièce (7) en un matériau rigide diélectrique qui est appliquée sur la face arrière du substrat dans les zones en contact avec la masse par des moyens de serrage et en ce que les moyens pour réaliser le contact électrique entre les conducteurs centraux des lignes coplanaires et des connecteurs coaxiaux sont des moyens de serrage des connecteurs coaxiaux pour maintenir les conducteurs centraux de ces connecteurs en pression avec flexion sur les conducteurs centraux des lignes coplanaires.

4. Dispositif selon la revendication 3, caractérisé en ce que les moyens de serrage de ladite troisième pièce (7) comprennent d'abord une dite quatrième pièce diélectrique (8) coulissant dans un évidement central de la première pièce du dispositif parallèlement à l'axe de symétrie du dispositif, cette quatrième pièce étant plaquée contre la face avant du susbstrat par l'action d'un ressort (9) qui s'appui d'autre part sur le fond de l'évidement de ladite première pièce, et comprennent ensuite un étrier (13) fixé à l'extrémité de ladite deuxième pièce, cet étrier (13) étant muni d'une vis (3) dont le point de serrage par pression de la troisième pièce sur la face arrière du substrat pour obtenir la pression optimale des aires de masse en regard.

5. Dispositif selon la revendication 3 ou 4, caractérisé en ce que les moyens de serrage des connecteurs coaxiaux sont des vis qui tournent dans ladite première pièce et dont les pointes s'appuient sur les gaines des connecteurs coaxiaux.

6. Dispositif selon l'une des revendications 2 à 5, caractérisé en ce que les premières et secondes pièces (1, 2) sont en bronze, et en ce que les surfaces polies (30, 40) sont dorées.

7. Dispositif selon l'une des revendications 1 à 6, caractérisé en ce que le substrat (10) est en céramique, par exemple en alumine.

8. Dispositif selon l'une des revendications 1 à 7, caractérisé en ce que le substrat (10) est circulaire.

9. Dispositif selon la revendication 8, caractérisé en ce que les pièces sont de révolution.

## Claims

1. A testing apparatus for a high-frequency integrated circuit chip for transporting the input/output signals of this circuit by means of high-frequency lines (101, 102, ...) having a characteristic impedance adapted to measuring apparatus, characterized in that it comprises:

   - a first subassembly constituted by an insulating or dielectric substrate (10) carrying on the one hand the integrated circuit chip fixed on one (11) of its surfaces and on the other hand a network of high-frequency lines (101, 102, ...) of the coplanar type arranged on the same surface (11) (designated as front surface) according to a geometric configuration suitable to transport the signals emitted by the inputs/outputs of the integrated circuit to the peripheral regions of the substrate (10).

- a second subassembly for receiving the substrate (10) provided with the integrated circuit and with the coplanar network, this second subassembly further having means for producing a pressure of the mass regions (100) of the coplanar network on a mass surface of this second subassembly and means for forming a good and reproducible electrical contact between the central conductors (51, 52, 53) of the coplanar network and the central conductors of the coaxial lines supplying the measuring apparatus.

2. An apparatus as claimed in Claim 1, characterized in that, for receiving the substrate (10) provided with the integrated circuit and with the coplanar network (101, 102, ...) the second subassembly is mainly constituted by a so-called first part (1) and by a so-called second part (2) each having a flat polished surface (30, 40), these surfaces being fixed opposite to each other, with a shoulder in such a manner that this shoulder constitutes a mass surface belonging to the said first part suitable to be used as a recess for the substrate, the front surface of the substrate bearing on the flat and polished surface of the shoulder, and in that the said second subassembly comprises for its use as a recess for the coaxial connectors (4) of the high-frequency lines supplying the measuring apparatus circular openings which are provided in the first and second parts and in a number equal to that of the coplanar lines, distributed along the periphery of the said first and second parts according to a suitable geometry, such that each central conductor (5) of a coaxial connector (4) is caused to coincide with an end (51, 52, ...) of a central conductor of a coplanar line so that due to the position of these openings only the mass regions of the coplanar lines bear on the shoulder serving as mass (100), while the central conductors (51, 52, ...) of the coplanar lines bear on the central conductors (5) of the coaxial connectors (4).

3. An apparatus as claimed in Claim 2, characterized in that the means for producing the pressure of the mass regions of the coplanar lines on the mass region constituted by the shoulder are formed by a so-called third part (7) made on a rigid dielectric material which is pressed on the back surface of the substrate in the zones in contact with the mass by clamping means, and in that the means for establishing the electrical contact between the central conductors of the coplanar lines and the coaxial conductors are means for clamping the coaxial connectors so as to maintain the central conductors of these connectors with a flexed pressure on the central conductors of the coplanar lines.

4. An apparatus as claimed in Claim 3, characterized in that the means for clamping the said third part (7) comprise a so-called fourth dielectric part (8) sliding in a central recess of the first part of the apparatus parallel to the axis of symmetry of the apparatus, this fourth part being pressed against the front surface of the substrate by the effect of a spring (9) which bears with its other end on the bottom of the recess of the said first part, while said means further comprise a bracket (13) fixed to the end of the said second part, this bracket (13) being provided with a screw (3) whose driving point exerts pressure via the third part on the back surface of the substrate in order to obtain the optimum pressure of the oppositely arranged mass regions.

5. An apparatus as claimed in Claim 3 or 4, characterized in that the means for clamping the coaxial connectors are screws which turn in the said first part and whose tips bear on the sheaths of the coaxial connectors.

6. An apparatus as claimed in any one of Claims 2 to 5, characterized in that the first and second parts (1, 2) are made of bronze, and in that the polished surfaces (30, 40) are gold-plated.

7. An apparatus as claimed in any one of Claims 1 to 6, characterized in that the substrate (10) is made of ceramic material, for example of alumina.

8. An apparatus as claimed in any one of Claims 1 to 7, characterized in that the substrate (10) is circular.

9. An apparatus as claimed in Claim 8, characterized in that the parts are bodies of revolution.

**Ansprüche**

1.  Testanordnung für einen HF-IC-Chip zum Transportieren der HF-Eingangs-/Ausgangssignale der integrierten Schaltung über HF-Leitungen (101, 102 ...) einer angepaßten charakteristischen Impedanz zu Meßanordnungen, **dadurch gekennzeichnet,** daß die Testanordnung die nachfolgenden Elemente aufweist:
    - eine erste Teilanordnung, die aus einem isolierenden oder dielektrischen Substrat (10) besteht, wobei einerseits auf einer der Flächen (11) der IC-Chip und andererseits, auf derselben, als Vorderfläche bezeichneten Fläche ein Netzwerk von HF-Leitungen (101, 102 ...) vom koplanaren Typ entsprechend einer geometrischen Konfiguration vorgesehen ist, geeignet zum Transportieren der gelieferten Eingangs-/Ausgangssignale der integrierten Schaltung zu den Umfangsgebieten des Substrats,
    - eine zweite Teilanordnung zum Erhalten des Substrats (10) mit der integrierten Schaltung und dem koplanaren Netzwerk, wobei diese zweite Teilanordnung weiterhin Mittel aufweist zum Ausüben eines Druckes der Massengebiete (100) des koplanaren Netzwerkes auf ein Massengebiet dieser zweiten Teilschaltung, sowie Mittel zum Bilden eines einwandfreien und reproduzierbaren Kontaktes zwischen den zentralen Leitern (51, 52, 53) des koplanaren Netzwerkes und den zentralen Leitern der die Meßanordnungen speisenden Koaxialleitungen.

2.  Testanordnung nach Anspruch 1, **dadurch gekennzeichnet,** daß zum Erhalten des Substrats (10) mit der integrierten Schaltung und dem koplanaren Netzwerk (101, 102 ...) die zweite Teilanordnung hauptsächlich besteht aus einem sog. ersten Teil (1) und einem sog. zweiten Teil (2) mit je einer flachen polierten Oberfläche (30, 40), wobei diese Flächen derart mit einer Schulter gegenüber einander angeordnet sind, daß diese Schulter eine dem genannten ersten Teil zugeordnete Massenfläche bildet, die dazu geeignet ist, als Ausnehmung für das Substrat verwendet zu werden, wobei die Vorderseite des Substrats sich auf der flachen und polierten Oberfläche der Schulter befindet, und daß die zweite Teilanordnung zum Bilden einer Ausnehmung für die koaxialen Leiter (4) der die Testanordnungen speisenden HF-Leitungen in dem ersten und zweiten Teil vorgesehene kreisförmige Öffnungen aufweist, und zwar in ihrer Zahl entsprechend der der koplanaren Leitungen, verteilt über den Umfang des genannten ersten und zweiten Teils entsprechend einer geeigneten Geometrie, so daß jeder zentrale Leiter (5) des Koaxialleiters (4) mit einem Ende (51, 52 ...) des zentralen Leiters der koplanaren Leitung zusammentrifft, so daß durch die Lage dieser Öffnungen nur die Massengebiete der koplanaren Leitungen auf der als Masse (100) wirksamen Schulter vorgesehen sind, während die zentralen Leiter (51, 52 ...) der koplanaren Leitungen sich auf die zentralen Leiter (5) der Koaxialleitungen (4) abstützen.

3.  Testanordnung nach Anspruch 2, **dadurch gekennzeichnet,** daß die Mittel zum Erzeugen von Druck der Massengebiete der koplanaren Leitungen auf das durch die Schulter gebildete Massengebiet durch einen sog. dritten Teil (7) aus einem starren, dielektrischen Werkstoff gebildet werden, der durch Klemmittel auf der Rückseite des Substrats in den Kontaktzonen mit der Masse angebracht wird, und daß die Mittel zum Erzeugen des elektrischen Kontaktes zwischen den zentralen Leitern der koplanaren Leitungen und den Koaxialleitungen Mittel sind zum Klemmen der Koaxialleitungen um die zentralen Leiter dieser Verbindungselemente mit den zentralen Leitern der koplanaren Leitungen unter Federdruck zu halten.

4.  Testanordnung nach Anspruch 3, **dadurch gekennzeichnet,** daß die Klemmittel des dritten Teils (7) einen sog. vierten dielektrischen Teil (8) aufweisen, der in einer zentralen Ausnehmung des ersten Teils der Anordnung gleitet, und zwar parallel zur Symmetrieachse der Anordnung, wobei dieser vierte Teil mit Hilfe einer Feder (9) gegen die Vorderfläche des Substrats gedrückt wird, wobei diese Feder sich am anderen Ende am Boden der Ausnehmung des genannten ersten Teils abstützt, und daß diese Mittel weiterhin einen Bügel (13) aufweisen, der an dem Ende des genannten zweiten Teils befestigt ist, wobei dieser Bügel (13) mit einer Schraube (3) versehen ist, deren Spitze dazu dient, den dritten Teil gegen die Rückfläche des Substrats zu drücken zum Erhalten optimaler Druckverhältnisse der betreffenden Massengebiete.

5.  Testanordnung nach Anspruch 3 oder 4, **dadurch gekennzeichnet,** daß die Klemmittel der koaxialen Verbindungselemente Schrauben sind, die in dem ersten Teil drehen und deren Spitzen auf den Umhüllungen der koaxialen Verbindungselemente anliegen.

6. Testanordnung nach einem der Ansprüche 2 bis 5, **dadurch gekennzeichnet,** daß die ersten und zweiten Teile (1, 2) aus Bronze bestehen und daß die polierten Oberflächen (30, 40) vergoldet sind.

7. Testanordnung nach einem der Ansprüche 1 bis 6, **dadurch gekennzeichnet,** daß das Substrat (10) aus Keramik, beispielsweise Aluminium, besteht.

8. Testanordnung nach einem der Ansprüche 1 bis 7, **dadurch gekennzeichnet,** daß das Substrat (10) kreisförmig ist.

9. Testanordnung nach Anspruch 8, **dadurch gekennzeichnet,** daß die Teile Rotationskörper sind.

FIG.1

EP 0 232 564 B1

EP 0 232 564 B1

FIG.2

FIG.3